# EUROPEAN PATENT APPLICATION

(11) **EP 4 730 599 A1**
(43) Date of publication of application: **22.04.2026**
(21) Application number: 25205265.9
(22) Date of filing: 29.09.2025
(51) Int. Cl.: H02J 7/34, G06F 1/30, H02J 9/06

(54) **POWER LOSS PROTECTION SYSTEM AND ELECTRONIC DEVICE INCLUDING THE SAME**

(30) Priority: 18.10.2024 KR 20240142922
(71) Applicant: Samsung Electronics Co., Ltd., Suwon-si, Gyeonggi-do 16677 (KR)
(72) Inventor: KIL, Minsung, Suwon-si, Gyeonggi-do 16677 (KR); YEOM, Changhae, Suwon-si, Gyeonggi-do 16677 (KR)
(74) Representative: Kuhnen & Wacker Patent- und Rechtsanwaltsbüro PartG mbB

(57) **Abstract**

A Power Loss Protection, PLP, circuit may include a control logic circuit configured to generate first and second path control signals (PTH _CTRL1, PTH_CTRL2), an auxiliary power supply (120) including a first capacitor (CP1) associated with a first charge allowance voltage level, a second capacitor (CP2) associated with a second charge allowance voltage level lower than the first charge allowance voltage level, and a path control circuit (122) configured to control an electrical connection between the first capacitor (CP1) and the second capacitor (CP2) based on the first path control signal (PTH_CTRL1) and the second path control signal (PTH_CTRL2), and a PLP circuit (110) connected to the first capacitor (CP1) and configured to provide a charging power to the auxiliary power supply (120) by using an external power, and, charge the first capacitor (CP1) to the first charge allowance voltage level after charging the first capacitor (CP1) and the second capacitor (CP2) to the second charge allowance voltage level by providing the charging power.

## Description

### BACKGROUND

### 1. Field

The present disclosure is related to a Power Loss Protection (PLP) system and an electronic device including the same.

### 2. Description of Related Art

When power loss occurs in an electronic system, various power protection technologies have been adopted to protect data damages or system errors. One of the power protection technologies is a Power Loss Protection (PLP) system, which reliably stores data in a Sudden Power Off (SPO) situation where power is abruptly cut off, or supplies an auxiliary power to protect a system. The PLP system may include a device that accumulates and discharges energy, and allow an electronic system to be safely terminated when a power disruption occurs by using the accumulated energy. The PLP system may play an essential role by using batteries, capacitors, or energy storage devices.

However, a conventional PLP system has a problem related to charging efficiency. In the conventional PLP system, when the charge allowance voltages of various capacitors connected to the same power network are different, an entire set of capacitors may be charged based on the lowest charge allowance voltage. According to the conventional system, a capacitor may not be charged to its maximum capacity, energy may not be efficiently used. Consequently, in the conventional PLP system, the system performance may be deteriorated due to the failure to provide enough power in a sudden power-off state, or inefficient power management.

The above description is only for understanding the background of the present disclosure and may include information that is irrelevant to conventional technologies.

### SUMMARY

The present disclosure relates to a PLP system and an electronic device including the same to solve the above-described problem.

According to embodiments of the present disclosure, there is provided a Power Loss Protection (PLP) system, including a control logic circuit configured to generate a first path control signal and a second path control signal, an auxiliary power supply including a first capacitor associated with a first charge allowance voltage level, a second capacitor associated with a second charge allowance voltage level lower than the first charge allowance voltage level, and a path control circuit configured to control an electrical connection between the first capacitor and the second capacitor based on the first path control signal and the second path control signal, and a PLP circuit connected to the first capacitor and configured to provide a charging power to the auxiliary power supply by using an external power, and charge the first capacitor to the first charge allowance voltage level after charging the first capacitor and the second capacitor to the second charge allowance voltage level by providing the charging power. The control logic circuit is configured to transmit the second path control signal for electrically disconnecting the second capacitor from the first capacitor and the PLP circuit to the path control circuit in response to the second capacitor being charged to the second charge allowance voltage level.

According to embodiments of the present disclosure, there is provided an electronic device, including a main system configured to operate by using an output power, and a Power Loss Protection (PLP) system that provides the output power to the main system by using an external power or an internal power. The PLP system includes a control logic circuit configured to generate a first path control signal and a second path control signal, an auxiliary power supply including a first capacitor associated with a first charge allowance voltage level, a second capacitor associated with a second charge allowance voltage level lower than the first charge allowance voltage level, and a path control circuit configured to control an electrical connection between the first capacitor and the second capacitor based on the first path control signal and the second path control signal, and a PLP circuit connected to the first capacitor configured to provide a charging power to the auxiliary power supply by using the external power, and charge the first capacitor to the first charge allowance voltage level after charging the first capacitor and the second capacitor to the second charge allowance voltage level by providing the charging power. The control logic circuit is configured to transmit the second path control signal for electrically disconnecting the second capacitor from the first capacitor and the PLP circuit to the path control circuit in response to determining that the second capacitor is charged to the second charge allowance voltage level.

According to embodiments of the present disclosure, there is provided a Power Loss Protection (PLP) system including an auxiliary power supply including a first capacitor associated with a first charge allowance voltage level, a second capacitor associated with a second charge allowance voltage level lower than the first charge allowance voltage level, and a path control circuit configured to control an electrical connection between the first capacitor and the second capacitor based on a first path control signal and a second path control signal, and a PLP circuit connected to the first capacitor and configured to provide a charging power to the auxiliary power supply by using an external power, transmit the first path control signal for electrically connecting the second capacitor to the first capacitor and the PLP circuit to the path control circuit, charge the first capacitor and the second capacitor to the second charge allowance voltage level, and charge the first capacitor to the first charge allowance voltage level by transmitting the second path control signal for electrically disconnecting the second capacitor from the first capacitor and the PLP circuit to the path control circuit in response to determining that the second capacitor is charged to the second charge allowance voltage level.

Compared to a reference example in which capacitors are charged to a lowest charge allowance voltage level in a power device including capacitors with different charge allowance voltage levels, the embodiments of the present disclosure may store more electrical energy to enhance the energy efficiency of the PLP system.

The effect that is obtained from the present disclosure is not limited to the above. The technical effect not mentioned above may be explicitly known to the those skilled in the art from the description below.

### BRIEF DESCRIPTION OF DRAWINGS

Embodiments will be more clearly understood from the following detailed description taken in conjunction with the accompanying drawings in which:
FIG. 1 is a block view illustrating an example of an electronic device according to embodiments of the present disclosure;
FIG. 2 is a view illustrated to explain an example of a PLP circuit of a PLP system according to embodiments of the present disclosure;
FIG. 3 is a view illustrated to explain an example of a PLP system according to embodiments of the present disclosure;
FIG. 4 to FIG. 7 are views illustrated to explain an example of a charging method of an auxiliary power supply according to embodiments of the present disclosure;
FIG. 8 to FIG. 11 are views illustrated to explain an example of a recharging method of an auxiliary power supply according to embodiments of the present disclosure;
FIG. 12 to FIG. 14 are views illustrated to explain an example of an internal power supply method device according to embodiments of the present disclosure;
FIG. 15 is a view illustrated to explain an example of a PLP system according to embodiments of the present disclosure;
FIG. 16 is a block view illustrating an example of an electronic device according to embodiments of the present disclosure; and
FIG. 17 is a block view illustrating an SSD system including an electronic device according to embodiments of the present disclosure.

### DETAILED DESCRIPTION

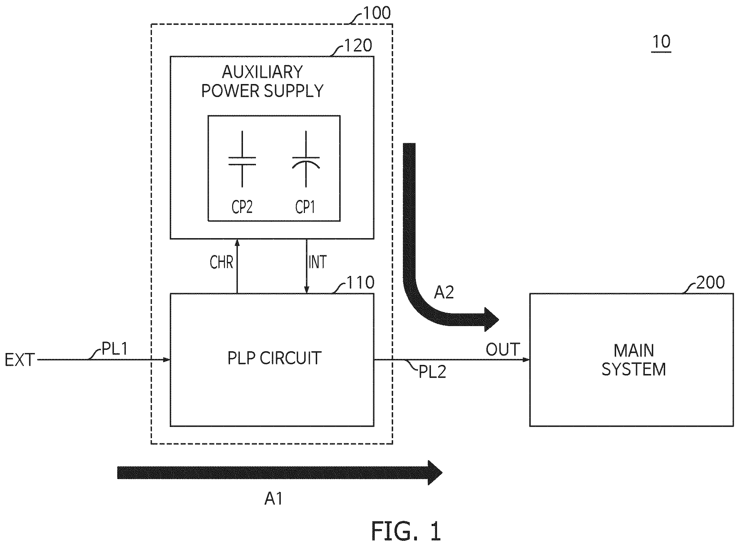

Referring to FIG. 1 to FIG. 17, various embodiments of the present disclosure will be described in detail. Like reference numerals in the drawings denote like elements, and the redundant description will be omitted.

FIG. 1 is a block view illustrating an example of an electronic device 10 according to embodiments of the present disclosure. The electronic device 10 may include a Power Loss Protection (PLP) system 100 and a main system 200. The PLP system 100 may provide an output power OUT to the main system 200, and the main system 200 may operate by using the output power OUT provided from the PLP system 100.

The PLP system 100 may provide the output power OUT to the main system 200 by using an external power EXT or an internal power INT. According to embodiments, the external power EXT may be referred to as a main power, and the internal power INT may be referred to as an auxiliary power. According to embodiments, the PLP system 100 may detect the voltage of the external power EXT supplied through a first power line PL1. The PLP system 100 may operate in an external power mode or an internal power mode based on the voltage of the external power EXT.

For example, when the external power EXT supplied through the first power line PL1 is properly supplied to the PLP system 100, the PLP system 100 may provide the output power OUT using the external power EXT. For example, when the voltage of the external power EXT supplied through the first power line PL1 is higher than or equal to a first predetermined voltage level, the PLP system 100 may allow the external power EXT to be output to a second power line PL2 and block the internal power INT from being output to the second power line PL2. As illustrated by a first arrow A1, the external power EXT may be supplied to the main system 200 through the PLP system 100. When the external power EXT is supplied to the main system 200 through the PLP system 100 as illustrated by the first arrow A1, the PLP system 100 may be referred to as 'operating in an external power mode'.

In a Sudden Power Off (SPO) situation where a power is suddenly cut off during a time period when the electronic device 10 operates, the external power EXT may not be properly supplied to the PLP system 100. When the external power EXT supplied through the first power line PL1 is not properly supplied to the PLP system 100, the PLP system 100 may provide the output power OUT by using the internal power INT. For example, when the voltage of the external power EXT supplied through the first power line PL1 is lower than the first predetermined voltage level, the PLP system 100 may block the external power EXT from being output to the second power line PL2 and provide the output power OUT by using the internal power INT. As illustrated by a second arrow A2, the output power OUT may be supplied to the main system 200 by using the internal power INT of the PLP system 100. When the output power OUT is supplied using the internal INT of the PLP system 100, the internal power INT may be converted and supplied to have a constant voltage level (e.g., a second predetermined voltage level) in the PLP system 100. As illustrated by the second arrow A2, when the output power OUT is supplied using the internal power INT of the PLP system 100, the PLP system 100 may be referred to as 'operating in an internal power mode'.

The PLP system 100 may include a PLP circuit 110 and an auxiliary power supply 120. The auxiliary power supply 120 may include two or more capacitors CP1 and CP2. According to embodiments, the auxiliary power supply 120 may include two or more capacitors CP1 and CP2 having different charge allowance voltage levels. For example, the auxiliary power supply 120 may include a first capacitor CP1 associated with a first charge allowance voltage level and a second capacitor CP2 associated with a second charge allowance voltage level lower than the first charge allowance voltage level.

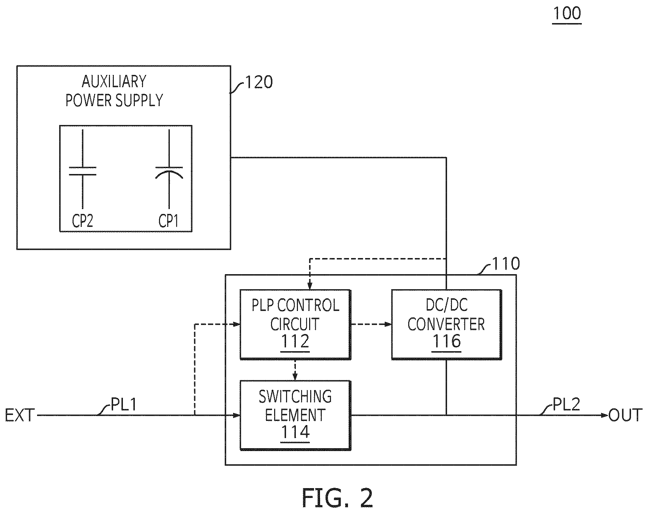

The PLP circuit 110 may provide a charging power CHR to the auxiliary power supply 120 and/or receive the internal power INT from the auxiliary power supply 120. For example, when the PLP system 100 operates in the external power mode, the PLP circuit 110 may repeatedly charge two or more capacitors CP1 and CP2 included in the auxiliary power supply 120 by using the external power EXT supplied through the first power line PL1. When the PLP system 100 operates in the external power mode, the PLP circuit 110 may provide the charging power CHR to the auxiliary power supply 120 by using the external power EXT. According to embodiments, the auxiliary power supply 120 includes two or more capacitors CP1 and CP2 having different charge allowance voltage levels, the PLP circuit 110 may provide the charging power CHR to charge each of the two or more different capacitors CP1 and CP2 to a charge allowance voltage level associated with each of the capacitors CP1 and CP2. The above description will be more detailed below with reference to FIG. 2 to FIG. 15. In addition, when the PLP system 100 operates in the internal power mode, the auxiliary power supply 120 may provide energy stored in at least one of the two or more capacitors CP1 and CP2 to the PLP circuit 110 as the internal power INT.

The main system 200 may operate using the output power OUT supplied through the second power line PL2. When the external power EXT is properly supplied to the PLP system 100, the main system 200 may operate using the external power EXT provided as the output power OUT. When the external power EXT is not properly supplied to the PLP system 100, such as in a sudden power-off situation, the main system 200 may operate using the output power Out provided using the internal power INT of the PLP system 100. For example, the main system 200 may complete an ongoing operation and perform data backup by using the output power OUT.

According to embodiments, the electronic device 10 may include a storage device (e.g., a Solid State Drive (SSD), etc.). For example, the electronic device 10 may include a non-volatile memory device including at least one flash memory chip (e.g., a NAND memory chip) for storing data.

According to embodiments, the electronic device 10 may be an embedded MultiMedia Card (eMMC) or an embedded Universal Flash Storage (UFS) memory device. For example, the electronic device 10 may be a UFS memory card, a Compact Flash (CF), a Secure Digital (SD), a Micro Secure Digital (Micro-SD), a Mini Secure Digital (Mini-SD), an extreme Digital (xD), or a Memory Stick. N However, the electronic device 10 according to the present disclosure is not limited to being a memory system. According to example embodiments, the electronic device 10 may be any electronic device that performs a Power Loss Protection function by providing an auxiliary power to the main system 200 in a sudden power-off situation.

FIG. 2 is a view illustrated to explain a PLP circuit 110 of a PLP system according to embodiments of the present disclosure. The redundant description will be omitted or briefly made, and the explanation will focus on the additional and changed description.

Referring to FIG. 2, a PLP system 100 may include a PLP circuit 110 and an auxiliary power supply 120.

The auxiliary power supply 120 may include two or more capacitors CP1 and CP2 having different charge allowance voltage levels. For example, the auxiliary power supply 120 may include a first capacitor CP1 associated with a first charge allowance voltage level and a second capacitor CP2 associated with a second charge allowance voltage level lower than the first charge allowance voltage level.

The PLP circuit 110 may provide an output power OUT to the main system by using an external power EXT or an internal power. For example, the PLP circuit 110 may detect the voltage of the external power EXT. In response to determining that the voltage of the external power EXT is higher than or equal to the first predetermined voltage level, the PLP circuit 110 may provide the output power OUT to the main system by using the external power EXT. In response to determining that the voltage of the external power EXT is lower than the first predetermined voltage level, the PLP circuit 110 may provide the output power OUT to the main system by using the internal power.

During a time period when the PLP circuit 110 provides the output power OUT to the main system by using the external power EXT (i.e., during a time period when the PLP system 100 operates in an external power mode), the PLP circuit 110 may repeatedly charge the capacitors CP1 and CP2 included in the auxiliary power supply 120. During a time period when the PLP circuit 110 provides the output power OUT to the main system by using the internal power (i.e., during a time period when the PLP system 100 operates in the internal power mode), the auxiliary power supply 120 may provide energy stored in at least one of the capacitors CP1 and CP2 to the PLP circuit 110 as the internal power.

According to embodiments, the PLP circuit 110 may include a PLP control circuit 112, a switching element 114, and a DC/DC converter 116.

The switching element 114 may control the electrical connection between the first power line PL1 to which the external power EXT is supplied and the second power line PL2 where the output power OUT is supplied to the main system. For example, the switching element 114 may electrically connect between the first power line PL1 and the second power line PL2 based on a first switching control signal. When the switching element 114 electrically connects the first power line PL1 and the second power line PL2, the external power EXT may be supplied to the output power OUT through the second power line PL2. The switching element 114 may electrically disconnect the first power line PL1 and the second power line PL2 based on a second switching control signal. When the switching element 114 electrically disconnects the first power line PL1 and the second power line PL2, the external power EXT may be blocked from being supplied to the second power line PL2.

The DC/DC converter 116 may be a bidirectional DC/DC converter that converts the voltage of the external power EXT or the voltage of the internal power. Converting the voltage may include maintaining, boosting, and bucking of the voltage of the power. For example, the DC/DC converter 116 may boost the voltage of the external power EXT to the second predetermined voltage level to provide the charging power to the auxiliary power supply 120 based on a first converting signal. The DC/DC converter 116 may stop boosting of the voltage of the external power EXT to the second predetermined voltage level based on a second converting signal. For example, the DC/DC converter 116 may stop providing the charging power to the auxiliary power supply 120 based on the second converting signal. In addition, the DC/DC converter 116 may reduce the voltage of the internal power to a third predetermined voltage level based on a third converting signal to provide the output power OUT to the main system.

The PLP control circuit 112 may detect the voltage of the external power EXT. In addition, the PLP control circuit 112 may control the switching element 114 based on the voltage detection result for the external power EXT. For example, the PLP control circuit 112 may detect the voltage of the external power EXT and in response to determining that the voltage of the external power EXT is higher than or equal to the first predetermined voltage level, transmit a first switching control signal for electrically connecting the first power line PL1 to the second power line PL2 to the switching element 114. In addition, the PLP control circuit 112 may transmit a second switching control signal for electrically disconnecting the first power line PL1 from the second power line PL2 to the switching element 114 in response to determining that the voltage of the external power EXT is lower than the first predetermined voltage level.

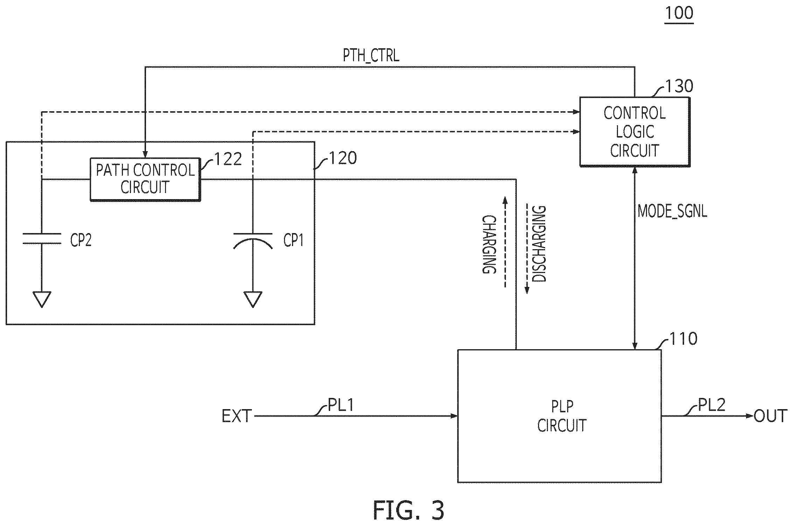

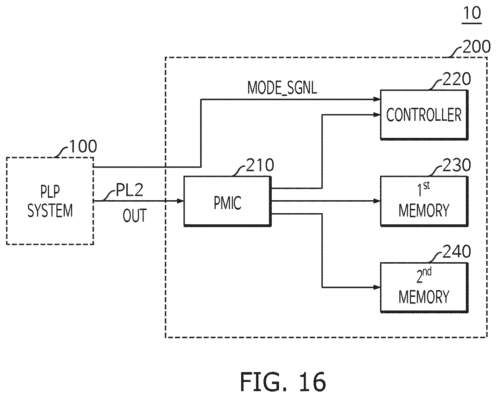

According to embodiments, the PLP control circuit 112 may generate a mode signal based on the voltage detection result for the external power EXT. For example, the PLP control circuit 112 may detect the voltage of the external power EXT and in response to determining that the voltage of the external power EXT is higher than or equal to the first predetermined voltage level, generate a first mode signal indicating the external power mode. The PLP control circuit 112 may generate a second mode signal indicating the internal power mode in response to determining that the voltage of the external power EXT is lower than the first predetermined voltage level. The PLP control circuit 112 may transmit a mode signal to the main system 200 (e.g., a controller 220 of FIG. 16) and/or a control logic circuit (e.g., 130 of FIG. 3).

According to embodiments, the PLP control circuit 112 may detect a voltage associated with the auxiliary power supply 120. In addition, the PLP control circuit 112 may control the DC/DC converter 116 based on the voltage detection result for the voltage associated with the auxiliary power supply 120. For example, the PLP control circuit 112 may detect the voltage of the first capacitor CP1 included in the auxiliary power supply 120. In addition, the PLP control circuit 112 may transmit the converting signal (e.g., the first converting signal, the second converting signal, the third converting signal, etc.) for controlling the DC/DC converter 116 to the DC/DC converter 116 based on the voltage of the first capacitor CP1 and/or the voltage of the external power EXT.

According to embodiments, the PLP control circuit 112 may include a voltage detection element and/or an Analog-to-Digital Converter (ADC) for detecting the voltage (the voltage of the external power EXT, the voltage associated with the auxiliary power supply 120).

FIG. 3 is a view illustrate to explain an example of a PLP system 100 according to embodiments of the present disclosure. The redundant description will be omitted or briefly made, and the explanation will focus on the additional and changed description.

According to embodiments, a PLP system 100 may include a PLP circuit 110, an auxiliary power supply 120, and a control logic circuit 130.

The auxiliary power supply 120 may include a first capacitor CP1 associated with the first charge allowance voltage level and a second capacitor CP2 associated with the second charge allowance voltage level lower than the first charge allowance voltage level. The first capacitor CP1 included in the auxiliary power supply 120 may be electrically connected to the PLP circuit 110. The second capacitor CP2 included in the auxiliary power supply 120 may be selectively connected to the PLP circuit 110.

According to embodiments, the first capacitor CP1 and the second capacitor CP2 may be different types of capacitors. For example, the first capacitor CP1 may be an aluminum capacitor (e.g., an electrolytic aluminum capacitor, etc.), and the second capacitor CP2 may be a tantalum capacitor (e.g., a polymer tantalum capacitor, etc.). According to embodiments, the first capacitor CP1 and the second capacitor CP2 may be capacitors having the same maximum voltage specification (e.g., 35 V, etc.), or different voltage derating margins (e.g., 85%, 80%, etc., respectively), which means the capacitors having different charge allowance voltage levels. However, the above-described examples are only for understanding of the present disclosure and are not limit the scope of the present disclosure.

FIG. 3 illustrates that the auxiliary power supply 120 includes one first capacitor CP1 and one second capacitor CP2, but it is only for the convenience of explanation and not limited thereto. For example, the auxiliary power supply 120 may include a plurality of first capacitors (e.g., a plurality of first capacitors connected in parallel with each other) and/or a plurality of second capacitors (e.g., a plurality of second capacitors connected in parallel with each other). In addition, the auxiliary power supply 120 may include three or more capacitors with different charge allowance voltage levels.

According to embodiments, the auxiliary power supply 120 may further include a path control circuit 122. The path control circuit 122 may be interposed between the first capacitor CP1 and the PLP circuit 110, and the second capacitor CP2. For example, one end of the path control circuit 122 may be electrically connected to the first capacitor CP1 and the PLP circuit 110, and the other end of the path control circuit 122 may be electrically connected to the second capacitor CP2. For example, the first capacitor CP1 is connected to the PLP circuit 110.

The path control circuit 122 may control the electrical connection between the first capacitor CP1 and the second capacitor CP2 based on a path control signal PATH_CTRL. For example, the path control circuit 122 may electrically connect the second capacitor CP2 to the first capacitor CP1 and the PLP circuit 110 based on a first path control signal. In addition, the path control circuit 122 may electrically disconnect the second capacitor CP2 from the first capacitor CP1 and the PLP circuit 110 based on a second path control signal.

According to embodiments, the path control circuit 122 may include a switch element capable of allowing a current to flow between the first capacitor CP1 and the second capacitor CP2 when the switch element is in a turned on state. According to embodiments, the path control circuit 122 may include a switch element having a slow turning on function to prevent a rapid current or voltage increase.

The control logic circuit 130 may control the path control circuit 122 by generating the path control signal PATH_CTRL. For example, the control logic circuit 130 may detect the voltage of the first capacitor CP1 and/or the voltage of the second capacitor CP2. The control logic circuit 130 may generate the path control signal PATH_CTRL (e.g., the first path control signal for electrically connecting the second capacitor CP2 to the first capacitor CP1 and the PLP circuit 110, the second path control signal for electrically disconnecting the second capacitor CP2 from the first capacitor CP1 and the PLP circuit 110, etc.) based on the voltage detection result.

According to embodiments, the control logic circuit 130 may receive a mode signal MODE_SGNL from the PLP circuit 110 and generate the path control signal PATH_CTRL based on the mode signal MODE_SGNL and the voltage detection result. For example, after receiving a first mode signal indicating the external power mode (i.e., during a time period when the PLP system 100 operates in the external power mode), the control logic circuit 130 may detect the voltage of the second capacitor CP2 and generate the path control signal PATH_CTRL based on the voltage of the second capacitor CP2. After receiving a second mode signal indicating an internal power mode (i.e., during a time period when the PLP system 100 operates in the internal power mode), the control logic circuit 130 may detect the voltage of the first capacitor CP1 and the voltage of the second capacitor CP2, and generate the path control signal PATH_CTRL based on the voltage of the first capacitor CP1 and the voltage of the second capacitor CP2.

According to embodiments, the control logic circuit 130 may generate the second path control signal to electrically disconnect the second capacitor CP2 from the first capacitor CP1 in a faulty state (e.g., a short state) of the second capacitor CP2. For example, the control logic circuit 130 may generate the second path control signal for electrically disconnecting the second capacitor CP2 from the first capacitor CP1 in response to determining that the voltage of the second capacitor CP2 is lower than a predetermined voltage level (e.g., 3 V, etc.).

According to embodiments, the PLP control circuit 112 may include a voltage detection element and/or an Analog-to-Digital Converter (ADC) to detect the voltage (e.g., the voltage of the first capacitor CP1 and the voltage of the second capacitor CP2). According to embodiments, the PLP control circuit 112 may include a logic element (e.g., a logic gate, etc.) and/or a control unit (e.g., a Microcontroller Unit (MCU), etc.) to generate a path control signal based on the voltage detection result.

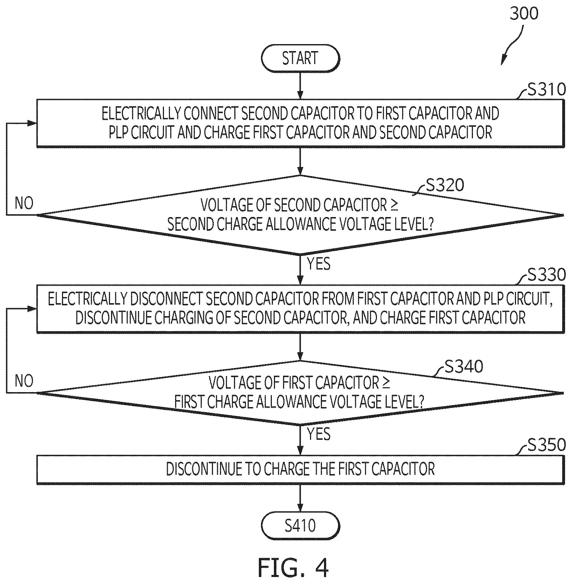

In the external power mode, the PLP system 100 may charge the auxiliary power supply 120 by using the external power EXT. For example, the PLP circuit 110 may provide a charging power to charge the first capacitor CP1 and the second capacitor CP2 to the second charge allowance voltage level, and charge the first capacitor CP1 to the first charge allowance voltage level. The above description will be detailed below with reference to FIG. 4 to FIG. 7.

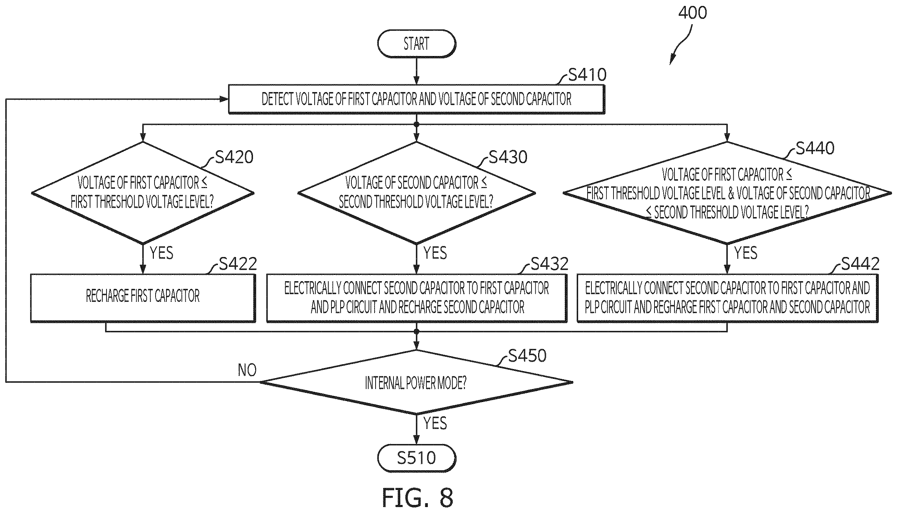

In the external power mode, the PLP system 100 may recharge the first capacitor CP1 and/or the second capacitor CP2 by using the external power EXT in response to the first capacitor CP1 and/or the second capacitor CP2 being discharged to a threshold voltage level associated with each of the capacitors CP1 and CP2. The above description will be detailed below with reference to FIG. 8 to FIG. 11.

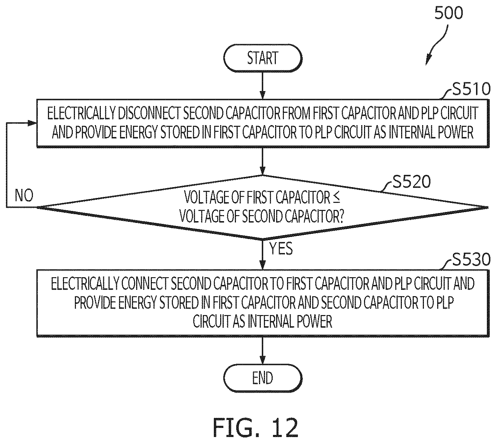

In the internal power mode, the auxiliary power supply 120 may provide only the energy stored in the first capacitor CP1 to the PLP circuit 110 as an internal power until the voltage of the first capacitor CP1 is equal to the voltage of the second capacitor CP2, and provide the energy stored in the first capacitor CP1 and the energy stored in the second capacitor CP2 to the PLP circuit 110 as the internal power. The above description will be detailed below with reference to FIG. 12 to FIG. 14.

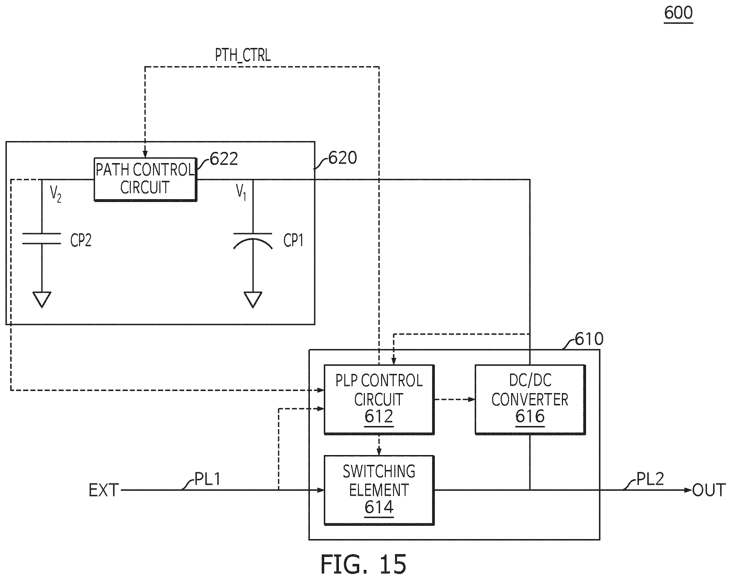

Referring to FIG. 3, the auxiliary power supply 120, the control logic circuit 130, and the PLP circuit 110 are illustrated and described as being implemented as separate configurations, the present invention is not limited thereto. For example, the control logic circuit 130 may be included in the PLP circuit 110 and/or the auxiliary power supply 120. At least part of the functions performed by the control logic circuit 130 may be performed by the PLP circuit 110 and/or the auxiliary power supply 120. An embodiment in which the control logic circuit 130 is included in the PLP circuit 110 will be described in more detail below with reference to FIG. 15.

FIG. 4 to FIG. 7 are views illustrated to explain an auxiliary power supply charging method 300 according to embodiments of the present disclosure. According to embodiments, the auxiliary power supply charging method 300 may be performed by the PLP system 100. The auxiliary power supply charging method 300 may be performed in the external power mode, i.e., during a time period when the PLP circuit 110 provides the output power OUT to the main system 200 by using the external power EXT.

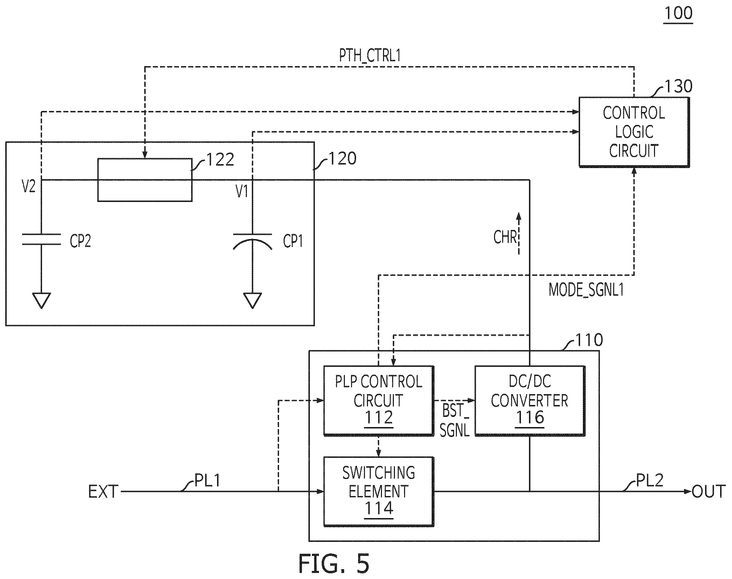

Referring to FIG. 4, the PLP system 100 may electrically connect the second capacitor CP2 to the first capacitor CP1 and the PLP circuit 110, and charge the first capacitor CP1 and the second capacitor CP2 in step S310. For example, as described in FIG. 5, the PLP control circuit 112 may transmit a first mode signal MODE_SGNL1 indicating the external power mode to the control logic circuit 130 based on determining that the voltage of the external power EXT is higher than or equal to the first predetermined voltage.

The PLP control circuit 112 may transmit a first converting signal BST_SGNL for controlling the external power EXT to be boosted to provide the charging power CHR to the auxiliary power supply 120 to the DC/DC converter 116 based on determining that a voltage V1 of the first capacitor CP1 is lower than or equal to a first threshold voltage level. The DC/DC converter 116 may boost the external power EXT to provide the charging power CHR to the auxiliary power supply 120 based on the first converting signal BST_SGNL.

The control logic circuit 130 may transmit a first path control signal PATH_CTRL1 for electrically connecting the second capacitor CP2 to the first capacitor CP1 and the PLP circuit 110 to the path control circuit 122 based on determining that a voltage V2 of the second capacitor CP2 is lower than or equal to a second threshold voltage level after receiving a first mode signal MODE_SGNL1 indicating the external power mode. The path control circuit 122 may electrically connect the second capacitor CP2 to the first capacitor CP1 and the PLP circuit 110 based on the first path control signal PATH _CTRL1. Accordingly, the first capacitor CP1 and the second capacitor CP2 may be charged using the charging power CHR when the second capacitor CP2 is electrically connected to the first capacitor CP1 and the PLP circuit 110.

Referring to FIG. 4, the PLP system 100 may monitor the voltage V2 of the second capacitor CP2 and determine whether the voltage V2 of the second capacitor CP2 reaches the second charge allowance voltage level in step S320. When it is determined that the voltage V2 of the second capacitor CP2 is lower than the second charge allowance voltage level (No in S320), the PLP system 100 may continue to charge the first capacitor CP1 and the second capacitor CP2 when the second capacitor CP2 is electrically connected to the first capacitor CP1 and the PLP circuit 110 in step S310.

In response to determining that the voltage V2 of the second capacitor CP2 reaches the second charge allowance voltage level (i.e., the second capacitor CP2 is charged to the second charge allowance voltage level) (Yes in step S320), the PLP system 100 may electrically disconnect the second capacitor CP2 from the first capacitor CP1 and the PLP circuit 110 and charge the first capacitor CP1 in step S330. In this case, the charging of the second capacitor CP2 may be stopped.

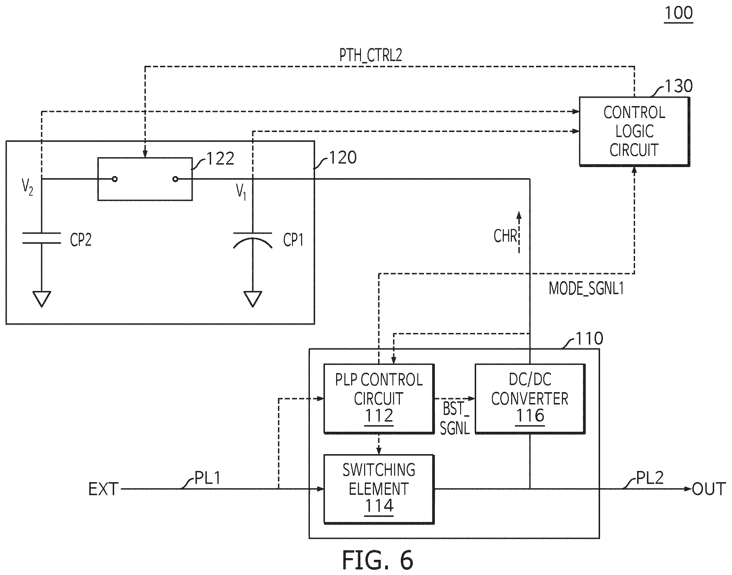

For example, as illustrated in FIG. 6, after receiving the first mode signal MODE_SGNL1 indicating the external power mode, based on determining that the voltage V2 of the second capacitor CP2 is higher than or equal to the second charge allowance voltage level, the control logic circuit 130 may transmit a second path control signal PATH_CTRL2 for electrically disconnecting the second capacitor CP2 from the first capacitor CP1 and the PLP circuit 110 to the path control circuit 122. The path control circuit 122 may electrically disconnect the second capacitor CP2 from the first capacitor CP1 and the PLP circuit 110 based on the second path control signal PATH_CTRL2. Accordingly, only the first capacitor CP1 may be charged using the charging power CHR when the second capacitor CP2 is electrically disconnected from the first capacitor CP1 and the PLP circuit 110.

Referring to FIG. 4, The PLP system 100 may monitor the voltage V1 of the first capacitor CP1 and determine whether the voltage V1 of the first capacitor CP1 reaches the first charge allowance voltage level in step S340. When it is determined that the voltage V1 of the first capacitor CP1 is lower than the first charge allowance voltage level (No in S340), the PLP system 100 may continue to charge the first capacitor CP1 when the second capacitor CP2 is electrically disconnected from the first capacitor CP1 and the PLP circuit 110 in step S330.

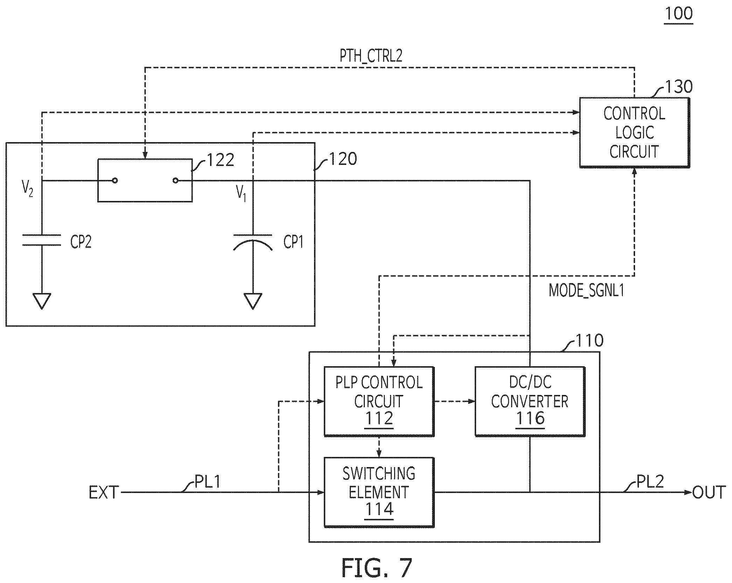

After receiving the first mode signal MODE_SGNL1 indicating the external power mode, in response to determining that the voltage V1 of the first capacitor CP1 is higher than or equal to the first charge allowance voltage level (Yes in S340), the PLP system 100 may stop charging the first capacitor CP1 in step S350. For example, referring to FIG. 7, the PLP control circuit 112 may transmit a second converting signal for controlling to stop boosting of the external power EXT to the DC/DC converter 116 based on determining that the voltage V1 of the first capacitor CP1 is higher than or equal to the first charge allowance voltage level. The DC/DC converter 116 may stop boosting of the external power EXT based on the second converting signal. Accordingly, the charging power CHR may be stopped from being provided to the auxiliary power supply 120.

According to some embodiments of the present disclosure, compared to a comparative example in which the capacitors CP1 and CP2 are charged only to the lowest charge allowance voltage level in an auxiliary power supply including capacitors CP1 and CP2 having different charge allowance voltage levels, more electric energy may be stored to enhance the energy efficiency of the PLP system 100.

FIG. 8 to FIG. 11 are views illustrated to explain an example of an auxiliary power supply recharging method 400 according to embodiments of the present disclosure. According to embodiments, the auxiliary power supply recharging method 400 may be performed by the PLP system 100. The auxiliary power supply recharging method 400 may be performed in the external power mode after the auxiliary power supply charging method (300 of FIG. 4) is terminated. The auxiliary power supply recharging method 400 may be initiated after the DC/DC converter 116 stops boosting of the external power EXT when the second capacitor CP2 is electrically disconnected from the first capacitor CP1 and the PLP circuit 110.

Referring to FIG. 8, the PLP system 100 may detect the voltage V1 of the first capacitor CP1 and the voltage V2 of the second capacitor CP2 in step S410. For example, the PLP circuit 110 may detect the voltage V1 of the first capacitor CP1, and the control logic circuit 130 may detect the voltages of the second capacitor CP2 and the first capacitor CP1.

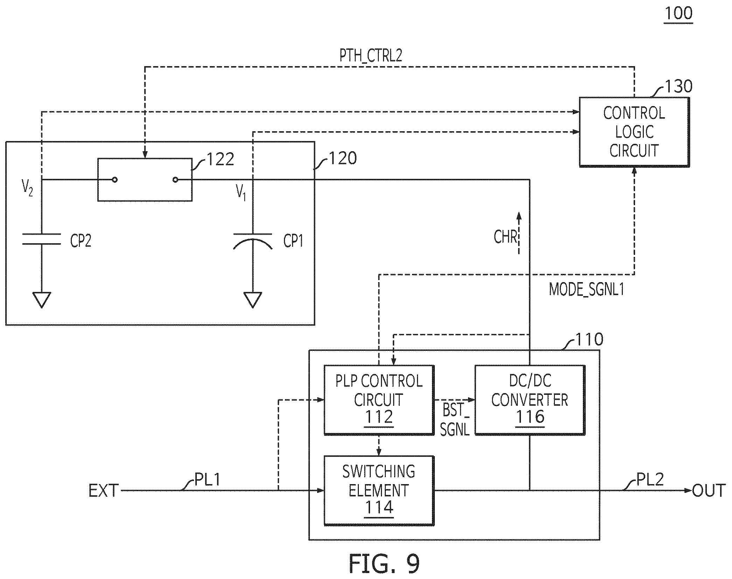

The PLP system 100, in response to determining that the voltage V1 of the first capacitor CP1 is lower than or equal to the first threshold voltage level in step S420, may recharge the first capacitor CP1 in step S422. For example, referring to FIG. 9, the PLP control circuit 112 may transmit the first converting signal BST_SGNL for controlling the external power EXT to be boosted to provide the charging power CHR to the auxiliary power supply 120 to the DC/DC converter 116, in response to determining that the voltage V1 of the first capacitor CP1 is lower than or equal to the first threshold voltage level. The DC/DC converter 116 may boost the external power EXT to provide the charging power CHR to the auxiliary power supply 120 based on the first converting signal BST_SGNL. Accordingly, the first capacitor CP1 may be recharged using the charging power CHR when the second capacitor CP2 is electrically disconnected from the first capacitor CP1 and the PLP circuit 110. The recharging of the first capacitor CP1 in step S422 may be performed until the voltage V1 of the first capacitor CP1 reaches the first charge allowance voltage level. The first threshold voltage level at which recharging of the first capacitor CP1 initiates may be lower than the first charge allowance voltage level.

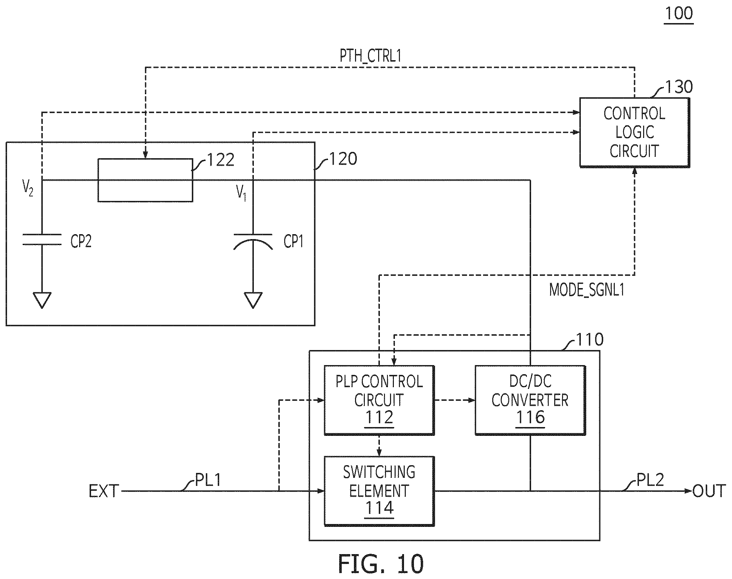

Referring to FIG. 8, in response to determining that the voltage V2 of the second capacitor CP2 is lower than or equal to the second threshold voltage level in step S430, the PLP system 100 may electrically connect the second capacitor CP2 to the first capacitor CP1 and the PLP circuit 110 and recharge the second capacitor CP2 in step S432. For example, referring to FIG. 10, the control logic circuit 130 may transmit the first path control signal PATH_CTRL1 for electrically connecting the second capacitor CP2 to the first capacitor CP1 and the PLP circuit 110 to the path control circuit 122 in response to determining that the voltage V2 of the second capacitor CP2 is lower than or equal to the second threshold voltage level. The path control circuit 122 may electrically connect the second capacitor CP2 to the first capacitor CP1 and the PLP circuit 110 based on the first path control signal PATH_CTRL1. Accordingly, the second capacitor CP2 may be recharged when the second capacitor CP2 is electrically connected to the first capacitor CP1 and the PLP circuit 110. The recharging of the second capacitor CP2 in step S432 may be performed until the voltage V2 of the second capacitor CP2 reaches the second charge allowance voltage level. The second threshold voltage level at which recharging of the second capacitor CP2 initiates may be lower than the second charge allowance voltage level. According to embodiments, the first threshold voltage level at which recharging of the first capacitor CP1 initiates may be higher than the second charge allowance voltage level associated with the second capacitor CP2, but the present invention is not limited thereto.

Referring to FIG. 8, although not shown, the detection of the voltage V1 of the first capacitor CP1 and the voltage V2 of the second capacitor CP2 in step S410 may be continuously performed during a time period when recharging of the first capacitor CP1 in step S422 and/or recharging of the second capacitor CP2 in step S432 are performed. When the voltage V2 of the second capacitor CP2 is determined to be lower than or equal to the second threshold voltage level during a time period when the recharging of the first capacitor CP1 in step S422 is performed, or when the voltage V1 of the first capacitor CP1 is determined to be lower than or equal to the first threshold voltage level during a time period when the recharging of the second capacitor CP2 in step S432 is performed, the PLP system 100 may recharge both the first capacitor CP1 and the second capacitor CP2 (e.g., proceed to S442).

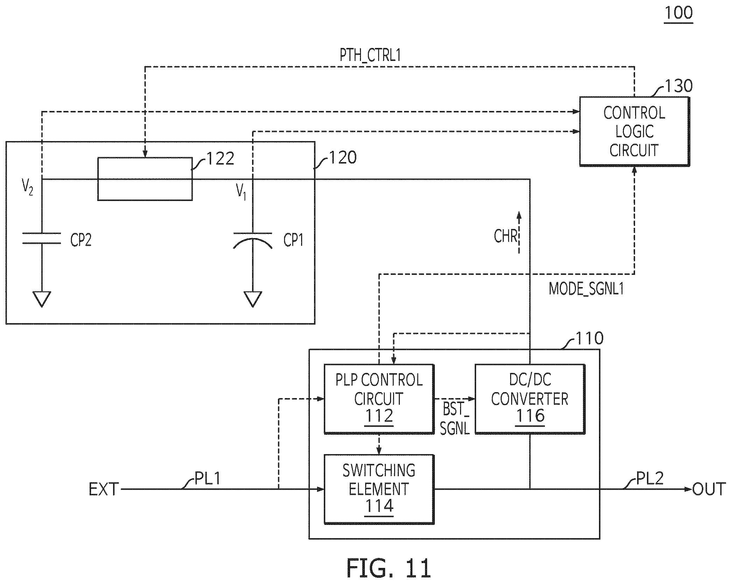

In response to determining that the voltage V1 of the first capacitor CP1 is lower than or equal to the first threshold voltage level and that the voltage V2 of the second capacitor CP2 is lower than or equal to the second threshold voltage level in step S440, the PLP system 100 may electrically connect the second capacitor CP2 to the first capacitor CP1 and the PLP circuit 110, and recharge the first capacitor CP1 and the second capacitor CP2 in step S442. For example, referring to FIG. 11, in response to determining that the voltage V1 of the first capacitor CP1 is lower than or equal to the first threshold voltage level, the PLP control circuit 112 may transmit the first converting signal BST_SGNL for controlling the external power EXT to be boosted to provide the charging power CHR to the auxiliary power supply 120 to the DC/DC converter 116. The DC/DC converter 116 may boost the external power EXT to provide the charging power CHR to the auxiliary power supply 120 based on the first converting signal BST_SGNL. The control logic circuit 130, in response to determining that the voltage V2 of the second capacitor CP2 is lower than or equal to the second threshold voltage level, may transmit the first path control signal PATH_CTRL1 for electrically connecting the second capacitor CP2 to the first capacitor CP1 and the PLP circuit 110 to the path control circuit 122. The path control circuit 122 may electrically connect the second capacitor CP2 to the first capacitor CP1 and the PLP circuit 110 based on the first path control signal PATH_CTRL 1. Accordingly, the first capacitor CP1 and the second capacitor CP2 may be recharged using the charging power CHR when the second capacitor CP2 is electrically connected to the first capacitor CP1 and the PLP circuit 110.

Referring to FIG. 8, although not shown, when the recharging of the first capacitor CP1 and the second capacitor CP2 in step S442 is performed, the detection of the voltage V1 of the first capacitor CP1 and the voltage V2 of the second capacitor CP2 in step S410 may be continuously performed. When the recharging of the first capacitor CP1 and the second capacitor CP2 in step S442 is performed, and it is determined that the voltage V2 of the second capacitor CP2 reaches the second charge allowance voltage level, the PLP system 100 may electrically disconnect the second capacitor CP2 from the first capacitor CP1 and the PLP circuit 110, and charge only the first capacitor CP1 (e.g., proceed to S422).

In the external power mode (No of S450), the PLP system 100 may repeatedly perform recharging of the first capacitor CP1 and/or the second capacitor CP2. When the external power mode is switched to the internal power mode (Yes of S450), the PLP system 100 may terminate the recharging method 400 of the auxiliary power supply 120 and perform an internal power supply method (500 of FIG. 12).

FIG. 12 to FIG. 14 are views illustrated to explain an example of an internal power supply method 500 according to embodiments of the present disclosure. According to embodiments, the internal power supply method 500 may be performed by the PLP system 100. The internal power supply method 500 may be performed in the internal power mode when the PLP circuit 110 provides the output power OUT to the main system 200 by using the internal power INT.

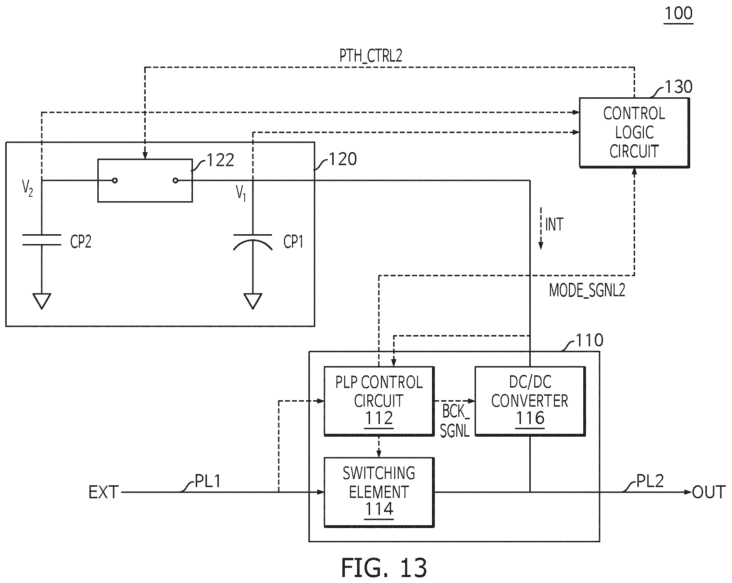

Referring to FIG. 12, The PLP system 100 may electrically disconnect the second capacitor CP2 from the first capacitor CP1 and the PLP circuit 110 in the internal power mode, and provide the energy stored in the first capacitor CP1 to the PLP circuit 110 as an internal power in step S510. For example, referring to FIG. 13, the PLP control circuit 112 may transmit a second mode signal MODE_SGNL2 indicating the internal power mode to the control logic circuit 130 based on determining that the voltage of the external power EXT is lower than the first predetermined voltage.

The PLP control circuit 112 may transmit a third converting signal BCK_SGNL for controlling the internal power INT to be stepped down to provide the output power OUT to the main system 200 based on determining that the voltage of the external power EXT is lower than a predetermined voltage to the DC/DC converter 116. The DC/DC converter 116 may perform voltage reduction of the internal power INT to provide the output power OUT to the main system 200 based on the third converting signal BCK_SGNL.

The control logic circuit 130, in response to determining that the voltage V1 of the first capacitor CP1 exceeds the voltage V2 of the second capacitor CP2 after receiving a second mode signal MODE_SGNL2 indicating the internal power mode, may transmit a second path control signal PTH_CTRL2 for electrically disconnecting the second capacitor CP2 from the first capacitor CP1 and the PLP circuit 110 to the path control circuit 122. The path control circuit 122 may electrically disconnect the second capacitor CP2 from the first capacitor CP1 and the PLP circuit 110 based on the second path control signal PTH_CTRL2. Accordingly, only the energy stored in the first capacitor CP1 may be provided to the PLP circuit 110 as the internal power INT.

Referring to FIG. 12, the PLP system 100 (e.g., the control logic circuit 130) may monitor the voltage V1 of the first capacitor CP1 and the voltage V2 of the second capacitor CP2, and determine whether the voltage V1 of the first capacitor CP1 is lower than or equal to the voltage V2 of the second capacitor CP2 in step S520. When it is determined that the voltage V1 of the first capacitor CP1 exceeds the voltage V2 of the second capacitor CP2 (No in step S520), the PLP system 100 may continuously provide the energy stored in the first capacitor CP1 to the PLP circuit 110 as the internal power INT when the second capacitor CP2 is electrically disconnected from the first capacitor CP1 and the PLP circuit 110 in step S510.

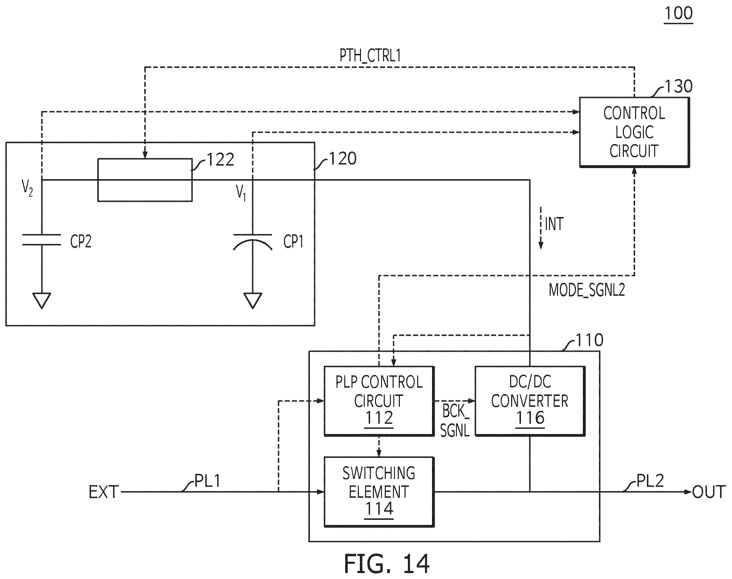

In response to determining that the voltage V1 of the first capacitor CP1 is lower than or equal to the voltage V2 of the second capacitor CP2 (Yes in step S520), the PLP system 100 may electrically connect the second capacitor CP2 to the first capacitor CP1 and the PLP circuit 110 and provide the energy stored in the first capacitor CP1 and the energy stored in the second capacitor CP2 to the PLP circuit 110 as the internal power in step S530. For example, referring to FIG. 14, the control logic circuit 130 may transmit a first path control signal PATH_CTRL1 for electrically connecting the second capacitor CP2 to the first capacitor CP1 and the PLP circuit 110 to the path control circuit 122 based on determining that the voltage V1 of the first capacitor CP1 is lower than or equal to the voltage V2 of the second capacitor CP2. The path control circuit 122 may electrically connect the second capacitor CP2 to the first capacitor CP1 and the PLP circuit 110 based on the first path control signal PTH_CTRL1. Accordingly, the energy stored in the first capacitor CP1 and the energy stored in the second capacitor CP2 may be provided to the PLP circuit 110 as the internal power INT.

The flowcharts of FIG. 4, FIG. 8, and FIG. 12, and the description with reference to FIG. 4 to FIG. 14 are only exemplary, and may be implemented differently in other embodiments. For example, in other embodiments, the order of each step may be changed, part of steps may be repeatedly performed, part of steps may be added, changed, omitted, or the entities performing at least part of steps may be changed. For example, even in a situation not described above, the control logic circuit 130 may generate the path control signal PTH_CTRL to appropriately charge or discharge the first capacitor CP1 and the second capacitor CP2. For example, the path control signal PTH_CTRL of the control logic circuit 130 according to the power mode, the voltage V1 condition of the first capacitor CP1, and the voltage V2 condition of the second capacitor CP2 may be generated as below in Table 1.

**[Table 1]**

| Power mode | V1 Condition | V2 Condition | Path Control Signal | Remarks |
|---|---|---|---|---|
| External Power Mode | V1≤Vth1 | V2≤Vth2 | PTH_CTRL1 | Initial Charge |
| External Power Mode | V1≤Vth1 | V2≥Vtarget2 | PTH_CTRL2 | CP2 Charge Completed |
| External Power Mode | V1≥Vtarget1 | V2≥Vtarget2 | PTH_CTRL2 | CP1 and CP2 Charge Completed |
| External Power Mode | V1≥Vtarget1 | V2≤Vth2 | PTH_CTRL1 | CP2 Recharge Start |
| Internal Power Mode | V1≥Vtarget1 | V2≥Vtarget2 | PTH_CTRL2 | Discharge from CP1 (Perform until V1≤V2) |
| Internal Power Mode | V1≥Vtarget1 | V2≤Vth2 | PTH_CTRL2 | When SPO occurs in the need of recharging CP2, Discharge from CP1 (Perform until V1≤V2) |
| Internal Power Mode | V1≤Vth1 | V2≥Vtarget2 | PTH_CTRL2 | Discharge from CP1 (Perform until V1≤V2) |
| Internal Power Mode | V1 = V2 | | PTH_CTRL1 | Discharge CP1 and CP2 Simultaneously |
| Internal Power Mode | V1≤Vth1 | V2≤Vth2 | PTH_CTRL1 | Maintain Discharge of CP1 and CP2 Simultaneously |

Referring to Table 1, Vtarget1, Vtarget2, Vth1 and Vth2 may refer to a first charge allowance voltage level, a second charge allowance voltage level, a first threshold voltage level, and a second threshold voltage level, respectively.

FIG. 15 is a view illustrated to explain an example of a PLP system 600 according to embodiments of the present disclosure. The redundant description will be omitted or briefly made, and the explanation will focus on the additional and changed description.

Referring to FIG. 15, the PLP system 600 may include a PLP circuit 610 and an auxiliary power supply 620.

The auxiliary power supply 620 may include a first capacitor CP1 associated with the first charge allowance voltage level, a second capacitor CP2 associated with the second charge allowance voltage level lower than the first charge allowance voltage level, and a path control circuit 622. The first capacitor CP1 included in the auxiliary power supply 620 may be electrically connected to the PLP circuit 610. In addition, the path control circuit 622 may be interposed between the first capacitor CP1 and the second capacitor CP2. For example, one end of the path control circuit 622 may be connected to the first capacitor CP1 and the PLP circuit 610, and the other end of the path control circuit 622 may be connected to the second capacitor CP2.

The path control circuit 622 may control the electrical connection between the first capacitor CP1 and the second capacitor CP2 based on the path control signal PATH_CTRL. For example, the path control circuit 622 may electrically connect the second capacitor CP2 to the first capacitor CP1 and the PLP circuit 610 based on the first path control signal. In addition, the path control circuit 622 may electrically disconnect the second capacitor CP2 from the first capacitor CP1 and the PLP circuit 610 based on the second path control signal.

According to embodiments, the PLP circuit 610 may include a PLP control circuit 612, a switching element 614 and a DC/DC converter 616.

The switching element 614 may control the electrical connection between the first power line PL1 supplied with the external power EXT and the second power line PL2 where the output power OUT is provided to the main system based on a switching control signal.

The DC/DC converter 616 may provide the charging power the auxiliary power supply by boosting the voltage of the external power EXT, or provide the output power OUT to the main system by performing voltage reduction of the voltage of the internal power based on a converting signal.

The PLP control circuit 612 may detect the voltage of the external power EXT. The PLP control circuit 612 may generate a switching control signal for controlling the switching element 614 based on the voltage detection result for the external power EXT. According to embodiments, the PLP control circuit 612 may generate and transmit a mode signal to the main system 200 (e.g., a controller included in the main system (e.g., 220 of FIG. 16)) based on the voltage detection result for the external power EXT.

The PLP control circuit 612 may detect a voltage associated with the auxiliary power supply 620. For example, the PLP control circuit 612 may detect the voltage V1 of the first capacitor CP1 and the voltage V2 of the second capacitor CP2.

According to embodiments, the PLP control circuit 612 may transmit the converting signal (e.g., the first converting signal, the second converting signal, the third converting signal, etc.) for controlling the DC/DC converter 616 to the DC/DC converter 616 based on the voltage V1 of the first capacitor CP1 and/or the voltage of the external power EXT.

According to embodiments, the PLP control circuit 612 may generate the path control signal PATH_CTRL to control the path control circuit 622 based on the voltage of the external power EXT, the voltage V1 of the first capacitor CP1 and/or the voltage V2 of the second capacitor CP2. For example, in the external power mode, a control logic circuit (not shown), in response to determining that the voltage V2 of the second capacitor CP2 is lower than or equal to the second threshold voltage, may transmit a first path control signal for electrically connecting the second capacitor CP2 to the first capacitor CP1 and the PLP circuit 610 to the path control circuit 622. In this case, the control logic circuit may be included in the PLP control circuit 612. The control logic circuit included in the PLP control circuit 612 may transmit a second path control signal for electrically disconnecting the second capacitor CP2 from the first capacitor CP1 and the PLP circuit 610 to the path control circuit 622 in response to determining that the second capacitor CP2 is charged to the second charge allowance voltage level in the external power mode.

FIG. 16 is a block view illustrating an example of an electronic device 10 according to embodiments of the present disclosure. The redundant description will be omitted or briefly made, and the explanation will focus on the additional and changed description.

Referring to FIG. 16, the electronic device 10 may include a PLP system 100 that supplies an output power OUT and a main system 200 that operates using the output power OUT. The main system 200 may include a power management circuit 210, a controller 220, a first memory 230, and a second memory 240.

The power management circuit 210 may provide the output power OUT supplied from the PLP system 100 to the internal components of the main system 200. The power management circuit 210 may receive the output power OUT from the PLP system 100 through a second power line PL2, generate output voltages suitable for the operation of each of the controller 220, the first memory 230, and the second memory 240, and provide the output voltages to the controller 220, the first memory 230, and the second memory 240. According to embodiments, the power management circuit 210 may be implemented as a Power Management Integrated Circuit (PMIC).

The controller 220 may control operations such as reading, writing, and erasing data of each of the first memory 230 and the second memory 240.

According to embodiments, the first memory 230 and the second memory 240 each may be a different type of memory. For example, the first memory 230 may include a volatile memory, and the second memory 240 may include a non-volatile memory. For example, the first memory 230 may include at least one of Static Random Access Memory (SRAM) and Dynamic RAM (DRAM), and the second memory 240 may include at least one of Flash Memory, Phase change RAM (PRAM), Ferroelectric RAM (FRAM), and Magnetic RAM (MRAM).

According to embodiments, one of the first memory 230 and the second memory 240 may be a cache memory and the other may be a main memory. For example, the first memory 230 may be a cache memory and the second memory 240 may be a main memory.

According to embodiments, in the internal power mode (i.e., during a time period when the PLP system 100 provides the output power OUT to the main system 200 by using the internal power), the main system 200 may store data stored in the first memory 230 in the second memory 240. For example, the controller 220 may receive a mode signal MODE_SGNL (e.g., a first mode signal indicating an external power mode, a second mode signal indicating an internal power mode, etc.) from the PLP system 100 (e.g., a PLP control circuit of a PLP circuit). After receiving the second mode signal indicating the internal power mode, the controller 220 may control the first memory 230 and the second memory 240 to back up the data stored in the first memory 230 to the second memory 240. Accordingly, the data stored in the main system 200 may be preserved in a sudden power-off (SPO) situation.

According to embodiments, the electronic device 10 may be a Solid State Drive (SSD). For example, when a DRAM is used as a cache memory in the first memory 230 and a NAND flash memory is used as a main memory in the second memory 240, the electronic device 10 may be an SSD, but the scope of the present disclosure is not limited thereto.

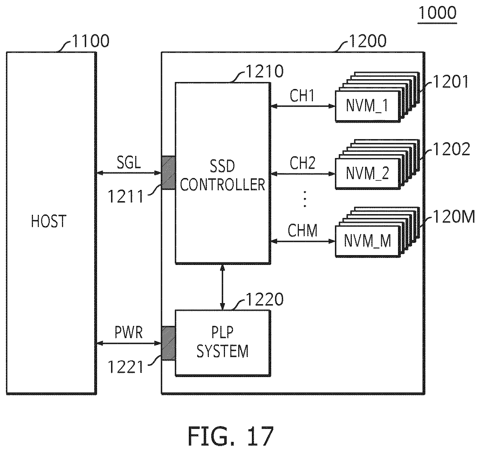

FIG. 17 is a block view illustrating a Solid State Drive (SSD) system 1000 including an electronic device according to embodiments of the present disclosure.

Referring to FIG. 17, the SSD system 1000 may include a host 1100 and an SSD 1200.

The SSD 1200 may exchange signals with the host 1100 through a signal connector 1211, and receive power through a power connector 1221. The SSD 1200 may include a plurality of flash memories 1201 to 120M, an SSD controller 1210, and a PLP system 1220. The SSD 1200 may correspond to at least one of the electronic devices described above (e.g., 10 of FIG. 1 or 10 of FIG. 16). The PLP system 1220 may correspond to at least one of the PLP systems described above (e.g., 100 of FIGS. 1-3, 5-7, 9-11, 13, and 14, or 600 of FIG. 15).

The plurality of flash memories 1201 to 120M may be used as a storage medium of the SSD 1200. In addition to the flash memory, non-volatile memory devices such as PRAM, MRAM, ReRAM, and FRAM may be used for the SSD 1200. The plurality of flash memories 1201 to 120M may be connected to the SSD controller 1210 through a plurality of channels CH1 to CHM. For example, one or more flash memories may be connected to one channel. The one or more flash memories connected to one channel may be connected to the same data bus. The SSD controller 1210, the plurality of channels CH1 to CHM, and the plurality of flash memories 1201 to 120M may correspond to at least one of the above-described main systems (e.g., 200 of FIG. 1 and FIG. 16).

The SSD controller 1210 may exchange signals SGL with the host 1100 through the signal connector 1211. The signal SGL may include a command, an address, data, etc. The SSD controller 1210 may write data to a corresponding flash memory or read data from a corresponding flash memory according to the commands from the host 1100.

The PLP system 1220 may be connected to the host 1100 via the power connector 1221. The PLP system 1220 may receive a power PWR from the host 1100 and charge an auxiliary power supply. The PLP system 1220 may be located inside the SSD 1200 or outside the SSD 1200. For example, the PLP system 1220 may be located on a main board to provide an auxiliary power to the SSD 1200.

While the inventive concept has been particularly shown and described with reference to embodiments thereof, it will be understood that various changes in form and details may be made therein without departing from the spirit and scope of the present invention as set forth in the following claims.

## Claims

1. A Power Loss Protection, PLP, system, (100; 600; 1220) comprising:
a control logic circuit (130) configured to generate a first path control signal (PTH_CTRL1) and a second path control signal (PTH_CTRL2);
an auxiliary power supply (120; 620) including:
a first capacitor (CP1) associated with a first charge allowance voltage level,
a second capacitor (CP2) associated with a second charge allowance voltage level lower than the first charge allowance voltage level, and
a path control circuit (122; 622) configured to control an electrical connection between the first capacitor (CP1) and the second capacitor (CP2) based on the first path control signal (PTH_CTRL1) and the second path control signal (PTH_CTRL2); and
a PLP circuit (110; 610) connected to the first capacitor (CP1) and configured to:
provide a charging power to the auxiliary power supply (120; 620) by using an external power, and
charge the first capacitor (CP1) to the first charge allowance voltage level after charging the first capacitor (CP1) and the second capacitor (CP2) to the second charge allowance voltage level by providing the charging power,
wherein the control logic circuit (130) is configured to transmit the second path control signal (PTH _CTRL2) for electrically disconnecting the second capacitor (CP2) from the first capacitor (CP1) and the PLP circuit (110; 610) to the path control circuit (122; 622) in response to the second capacitor (CP2) being charged to the second charge allowance voltage level.

2. The PLP system (100; 600; 1220) as claimed in claim 1, wherein the path control circuit (122; 622) includes one end connected to the first capacitor (CP1) and the PLP circuit (110; 610), and the other end connected to the second capacitor (CP2).

3. The PLP system (100; 600; 1220) as claimed in claim 1 or 2, wherein the PLP circuit (110; 610) is further configured to recharge the first capacitor (CP1) in response to a voltage of the first capacitor (CP1) being lower than or equal to a first threshold voltage level after the charging the first capacitor (CP1) to the first charge allowance voltage level, and
wherein the first threshold voltage level is lower than the first charge allowance voltage level.

4. The PLP system (100; 600; 1220) as claimed in claim 3, wherein the first threshold voltage level is higher than the second charge allowance voltage level.

5. The PLP system (100; 600; 1220) as claimed in any one of claims 1 to 4, wherein the control logic circuit (130) is further configured to recharge the second capacitor (CP2) by transmitting, to the path control circuit (122; 622), the first path control signal (PTH _CTRL1) for electrically connecting the second capacitor (CP2) to the first capacitor (CP1) and the PLP circuit (110; 610) in response to a voltage of the second capacitor (CP2) being lower than or equal to a second threshold voltage level after the second capacitor (CP2) is charged to the second charge allowance voltage level, and
wherein the second threshold voltage level is lower than the second charge allowance voltage level.

6. The PLP system (100; 600; 1220) as claimed in any one of claims 1 to 5, wherein the auxiliary power supply (120; 620) is configured to provide energy stored in at least one of the first capacitor (CP1) or the second capacitor (CP2) to the PLP circuit (110; 610) as an internal power, and
wherein the PLP circuit (110; 610) is further configured to provide an output power to a main system (200) outside the PLP system (100; 600; 1220) by using the external power or the internal power.

7. The PLP system (100; 600; 1220) as claimed in claim 6, wherein the PLP circuit (110; 610) is further configured to:
provide the output power to the main system (200) by using the external power in response to determining that a voltage of the external power is higher than or equal to a predetermined voltage level, and
provide the output power to the main system (200) by using the internal power in response to determining that the voltage of the external power is lower than the predetermined voltage level.

8. The PLP system (100; 600; 1220) as claimed in claim 6 or 7, wherein the PLP circuit (110; 610) is further configured to charge the first capacitor (CP1) and the second capacitor (CP2) during a time period when the output power is provided to the main system (200) by using the external power.

9. The PLP system (100; 600; 1220) as claimed in any one of claims 6 to 8, wherein during a time period when the PLP circuit (110; 610) provides the output power to the main system (200) by using the internal power:
the auxiliary power supply (120; 620) is further configured to provide energy stored in the first capacitor (CP1) and energy stored in the second capacitor (CP2) to the PLP circuit (110; 610) after providing the energy stored in the first capacitor (CP1) to the PLP circuit (110; 610), and
the control logic circuit (130) is further configured to:
detect a voltage of the first capacitor (CP1) and a voltage of the second capacitor (CP2), and
transmit the first path control signal (PTH_CTRL1) for electrically connecting the second capacitor (CP2) to the first capacitor (CP1) and the PLP circuit (110; 610) to the path control circuit (122; 622) in response to determining that a voltage of the first capacitor (CP1) is lower than or equal to a voltage of the second capacitor (CP2).

10. The PLP system (100; 600; 1220) as claimed in claim 9, wherein during the time period when the PLP circuit (110; 610) provides the output power to the main system (200) by using the internal power, the control logic circuit (130) is further configured to:
transmit the second path control signal (PTH _CTRL2) for electrically disconnecting the second capacitor (CP2) from the first capacitor (CP1) and the PLP circuit (110; 610) to the path control circuit (122; 622) in response to determining that the voltage of the first capacitor (CP1) is higher than the voltage of the second capacitor (CP2).

11. The PLP system (100; 600; 1220) as claimed in any one of claims 6 to 10, wherein the PLP circuit (110; 610) comprises:
a switching element (114; 614) configured to control an electrical connection between a first power line (PL1) to which the external power is supplied, and a second power line in which the output power is provided to the main system (200);
a DC/DC converter (116; 616) configured to provide the charging power to the auxiliary power supply (120; 620) by boosting a voltage of the external power, or provide the output power to the main system (200) by performing voltage reduction of the internal power; and
a PLP control circuit (112; 612) configured to detect the voltage of the external power and a voltage of the first capacitor (CP1), and control at least one of the switching element (114; 614) or the DC/DC converter (116; 616) based on the detected voltage.

12. The PLP system (100; 600; 1220) as claimed in claim 11, wherein the PLP control circuit (112; 612) is further configured to:
transmit a first switching control signal for electrically connecting the first power line (PL1) and the second power line (PL2) to the switching element (114; 614) in response to the determining that the voltage of the external power is higher than or equal to a predetermined voltage level, and
during a time period when the switching element (114; 614) maintains an electrical connection between the first power line (PL1) and the second power line (PL2) based on the first switching control signal:
transmit a first converting signal for controlling to provide the charging power to the auxiliary power supply (120; 620) by boosting the external power to the DC/DC converter (116; 616) in response to determining that the voltage of the first capacitor (CP1) is lower than or equal to a first threshold voltage level,
transmit a second converting signal for controlling to stop boosting of the external power to the DC/DC converter (116; 616) in response to determining that the voltage of the first capacitor (CP1) is higher than or equal to the first charge allowance voltage level, and
wherein the first threshold voltage level is lower than the first charge allowance voltage level.

13. The PLP system (100; 600; 1220) as claimed in claim 11 or 12, wherein the PLP control circuit (112; 612) is further configured to, in response to determining that the voltage of the external power is lower than a predetermined voltage level:
transmit a second switching control signal for electrically disconnecting the first power line (PL1) from the second power line (PL2) to the switching element (114; 614), and
transmit a third converting signal for controlling to provide the output power to the main system (200) by performing voltage reduction of the internal power to the DC/DC converter (116; 616).

14. The PLP system (100; 600; 1220) as claimed in any one of claims 1 to 13, wherein the PLP circuit (110; 610) is further configured to:
detect a voltage of the external power, and
transmit a first mode signal indicating an external power mode and a second mode signal indicating an internal power mode to the control logic circuit (130) based on the voltage of the external power.

15. The PLP system (100; 600; 1220) as claimed in claim 14, wherein the control logic circuit (130) is further configured to, after receiving the first mode signal, transmit the first path control signal (PTH_CTRL1) for electrically connecting the second capacitor (CP2) to the first capacitor (CP1) and the PLP circuit (110; 610) to the path control circuit (122; 622) in response to determining that a voltage of the second capacitor (CP2) is lower than or equal to a second threshold voltage level.
